# EUROPEAN PATENT APPLICATION

(11) **EP 4 813 911 A1**
(43) Date of publication of application: **30.09.2026**
(21) Application number: 25761394.3
(22) Date of filing: 17.02.2025
(51) Int. Cl.: C01B 32/164, C23C 16/26

(54) **CARBON NANOTUBE PRODUCTION DEVICE AND CARBON NANOTUBE MANUFACTURING DEVICE**

(30) Priority: 26.02.2024 JP 2024026886
(71) Applicant: Dowa Thermotech Co., Ltd., Chiyoda-ku Tokyo 101-0021 (JP); Meijo Nano Carbon Co., Ltd., Nagoya-shi, Aichi 463-0018 (JP)
(72) Inventor: FUJITA, Takahiro, Tokyo 101-0021 (JP); HASHIMOTO, Takeshi, Nagoya-shi, Aichi 463-0018 (JP); TAKANO, Kei, Nagoya-shi, Aichi 463-0018 (JP)
(74) Representative: Müller-Boré & Partner Patentanwälte PartG mbB
(86) International application number: PCT/JP2025/005146
(87) International publication number: WO 2025/182635

(57) **Abstract**

A carbon nanotube production apparatus producing a carbon nanotube, the carbon nanotube production apparatus including: a reaction tube to which a raw material gas for the carbon nanotube is supplied; a heater disposed circumferentially around the reaction tube; a heat insulator covering an outside of the heater; a hermetic case that hermetically encloses a periphery of the reaction tube and houses the heater and the heat insulator; a supply port supplying a shielding gas into an inside of the hermetic case; and a discharge port discharging the shielding gas from the inside of the hermetic case.

## Description

### TECHNICAL FIELD

The present invention relates to a carbon nanotube production apparatus producing a carbon nanotube and a carbon nanotube manufacturing apparatus.

### BACKGROUND ART

A carbon nanotube (hereinafter sometimes referred to as a "CNT") is a new material attracting attention in many fields due to its excellent properties such as electric conductivity, thermal conductivity, and mechanical strength. As an apparatus for manufacturing a CNT, Patent Document 1 discloses a manufacturing apparatus using a chemical vapor deposition method (CVD method) in which a raw material containing carbon (carbon source) is thermally decomposed to produce a CNT.

In a method for manufacturing a CNT using the chemical vapor deposition method, for example, a CNT raw material and a carrier gas are supplied to an inside of a reaction tube heated to a high temperature, and the raw material passes through the inside of the reaction tube for a certain period of time to produce a CNT. The produced CNT is discharged from an end portion of the reaction tube on a side opposite to a raw material supply side. Hydrocarbon is used as the raw material for the CNT, and a hydrogen gas is used as the carrier gas.

### PRIOR ART DOCUMENT

### PATENT DOCUMENT

Patent Document 1: Japanese Patent Application Laid-Open No. 2019-064918

### SUMMARY OF THE INVENTION

### PROBLEMS TO BE SOLVED BY THE INVENTION

An inside of a reaction tube serves as a reaction production region, and a heating source (e.g., an electric heater or the like) for heating the reaction tube is installed outside the reaction tube and heats the reaction tube from its outer periphery. Since CNT manufacturing needs to be performed at a high temperature and in a flammable gas atmosphere, the reaction tube is required to be made of a material that is heat-resistant, corrosion-resistant, and gas-impermeable at a high temperature. Materials satisfying these conditions include heat-resistant steel, tungsten, molybdenum, carbon, alumina, zirconia, mullite, SiC, and quartz.

However, these materials are different in performance and property such as heat resistance and corrosion resistance, respectively, and there are restrictions on their usage, and therefore, it is necessary to select the material for the reaction tube according to CNT manufacturing conditions (temperature, gas to be used). There is also a constraint on manufacturable dimensions of the reaction tube made of each material, and since a reaction tube size directly affects an amount of CNT production, a manufacturing capacity of the CNT depends on the material for the reaction tube. In essence, CNT manufacturing is subjected to a certain limitation depending on the selected reaction tube material. If the reaction tube is damaged, a flammable gas, which is a carrier gas, leaks, and the heating source installed outside the reaction tube could become an ignition source, potentially leading to a fire.

For example, heat-resistant steel has a service limit temperature of 1100°C and exhibits a property of being melted or damaged due to carburization. Additionally, tungsten, molybdenum, and carbon are severely consumed and thinned in an oxidizing atmosphere at 300°C or higher, resulting in damage. Furthermore, alumina, zirconia, mullite, SiC, and quartz cannot be rapidly heated or cooled because thermal shock leads to their damage.

Even when a reaction tube whose material is suitable for the CNT manufacturing conditions is selected, the reaction tube material undergoes qualitative changes due to repeated use over a long period, resulting in gradual change or deterioration of its initial performance and property. In such cases, the reaction tube may be damaged even under the same CNT manufacturing conditions.

If the reaction tube is damaged, the flammable gas, which is the carrier gas, leaks, and the heating source installed outside the reaction tube becomes an ignition source, potentially leading to a fire.

The present invention has been made in view of the above circumstances, and an object thereof is to provide a carbon nanotube production apparatus and a carbon nanotube manufacturing apparatus capable of reducing a risk of fire even when there is leakage of a flammable gas from a reaction system due to damage or the like of a reaction tube.

### MEANS FOR SOLVING THE PROBLEMS

One aspect of the present invention for solving the above problem is a carbon nanotube production apparatus producing a carbon nanotube, the carbon nanotube production apparatus including: a reaction tube to which a raw material gas for the carbon nanotube is supplied; a heater disposed circumferentially around the reaction tube; a heat insulator covering an outside of the heater; a hermetic case that hermetically encloses a periphery of the reaction tube and houses the heater and the heat insulator; a supply port supplying a shielding gas into an inside of the hermetic case; and a discharge port discharging the shielding gas from the inside of the hermetic case.

In this carbon nanotube production apparatus, the supply port may be provided at a lower portion of the hermetic case, and the discharge port may be provided at an upper portion of the hermetic case. Further, the carbon nanotube production apparatus may be configured to monitor a differential pressure between the inside of the reaction tube and a space to which the shielding gas is supplied, and to automatically adjust a supply flow rate of the shielding gas when the differential pressure exceeds a predetermined range, to thereby prevent leakage of the shielding gas into the reaction tube in the event of damage to the reaction tube.

One aspect of the present invention from another viewpoint is a carbon nanotube manufacturing apparatus including the above-described carbon nanotube production apparatus and a collection apparatus collecting a carbon nanotube.

### EFFECT OF THE INVENTION

According to the present invention, it is possible to provide a carbon nanotube production apparatus and a carbon nanotube manufacturing apparatus capable of reducing a risk of fire even in a case of leakage of a flammable gas from a reaction system due to damage to a reaction tube or the like.

### BRIEF DESCRIPTION OF THE DRAWINGS

FIG. 1 is an explanatory diagram illustrating a schematic configuration of a carbon nanotube manufacturing apparatus (CNT manufacturing apparatus) according to an embodiment of the present invention.
FIG. 2 is a flowsheet illustrating a method for manufacturing a CNT in the CNT manufacturing apparatus according to the embodiment of the present invention.

### EMBODIMENTS FOR CARRYING OUT INVENTION

Hereinafter, embodiments of the present invention will be described with reference to the drawings. In this specification and the drawings, elements having substantially the same functional configuration are denoted by the same reference signs, and redundant description thereof is omitted.

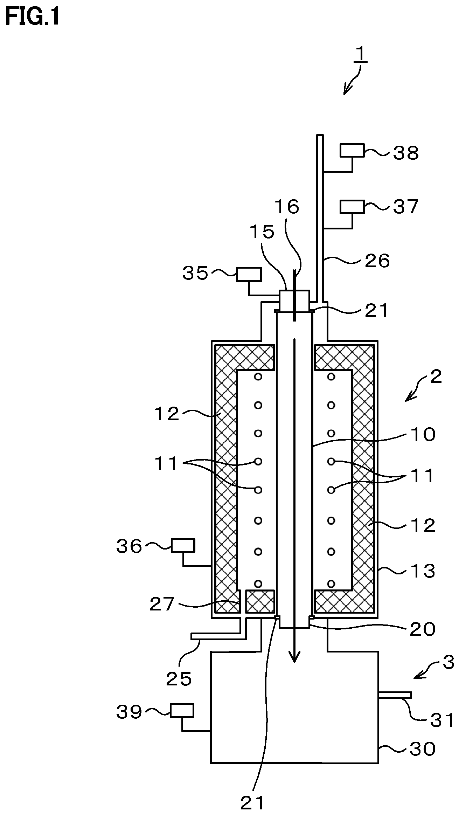

FIG. 1 is an explanatory diagram illustrating a schematic configuration of a CNT manufacturing apparatus 1 that manufactures a carbon nanotube (hereinafter sometimes referred to as a "CNT") according to the present embodiment. The CNT in this specification is a tubular carbon allotrope (typically cylindrical structure with a graphite structure) and includes what is called a single-walled CNT, a multi-walled CNT, and a carbon nanohorn with a horn-shaped tube tip. The CNT manufacturing apparatus 1 is suitably used for manufacturing the single-walled CNT, in particular.

The CNT manufacturing apparatus 1 includes a CNT production apparatus 2 producing a CNT and a collection apparatus 3 collecting the CNT. The collection apparatus 3 is connected to a lower end portion of the CNT production apparatus 2.

The CNT production apparatus 2 producing the CNT is an apparatus that produces a CNT using a chemical vapor deposition method (CVD method) in which a raw material such as a catalytic metal or a catalytic metal compound is thermally decomposed to produce the CNT. Note that when the CNT raw material is supplied to the CNT production apparatus 2, a carrier gas (e.g., hydrogen gas) is also supplied together with the raw material. In this specification, the raw material supplied together with the carrier gas is referred to as a raw material gas.

The production apparatus 2 includes a reaction tube 10 to which the raw material gas for the CNT is supplied, a heater 11 disposed to surround a periphery of the reaction tube 10, and a heat insulator 12 covering an outside of the heater 11.

A shape of the reaction tube 10 is not limited, but for example, a straight tubular shape (i.e., a shape in which an axis extends linearly) is preferable. Further, a cross-sectional shape of the reaction tube 10 may be a rounded shape such as a circle, an ellipse, an oval shape, or an oblong shape, or a polygonal shape. As a material for the reaction tube 10, for example, alumina (Al₂O₃), mullite, silicon carbide (SiC), quartz glass, Kanthal (iron-chromium-aluminum alloy), Inconel, carbon, or the like is used.

A shape and a heating method of the heater 11 are not particularly limited as long as the heater 11 can heat the reaction tube 10 to a temperature suitable for producing the CNT. The heater 11 only needs to be capable of heating the reaction tube 10 to, for example, 500°C to 2000°C, preferably 1000°C to 1600°C. Specific examples of the heater 11 include a tungsten heater capable of heating the reaction tube 10 to 500°C to 2000°C and a silicon carbide heater (SiC heater) capable of heating to 600 to 1600°C.

A hermetic case 13 that hermetically encloses a periphery of the reaction tube 10 is provided outside the reaction tube 10. Further, the heater 11 and the heat insulator 12 are housed inside this hermetic case 13.

An upper end portion 15 of the reaction tube 10 projects upward from the hermetic case 13, and an inlet unit 16 supplying a replacement gas or the raw material gas from the outside into the reaction tube 10 is provided at the upper end portion 15. A lower end portion 20 of the reaction tube 10 projects downward from the hermetic case 13 and opens on an upper surface of the collection apparatus 3.

Packings 21 are attached to an outer peripheral surface of the upper end portion 15 of the reaction tube 10 and an outer peripheral surface of the lower end portion 20 of the reaction tube 10. By the packings 21, a space inside the hermetic case 13 is maintained in a hermetic state in the periphery of the reaction tube 10.

A supply port 25 supplying a shielding gas into an inside of the hermetic case 13 is provided at a lower portion of the hermetic case 13, and a discharge port 26 discharging the shielding gas from the inside of the hermetic case 13 is provided at an upper portion of the hermetic case 13. By discharging a certain amount of shielding gas (inert gas, nitrogen, argon, etc.) from the discharge port 26 while making a certain amount of shielding gas flow from the supply port 25 into the inside of the hermetic case 13, an internal space of the hermetic case 13 is constantly maintained in an inert gas atmosphere. Note that the heat insulator 12 is provided with a hole 27 allowing the shielding gas to flow.

The collection apparatus 3 has a collection room 30 collecting the CNT produced by the CNT production apparatus 2, and an exhaust port 31 discharging an atmosphere inside the collection room 30 is provided in a side surface of the collection room 30. The gas supplied from the reaction tube 10 into the collection room 30 is discharged through this exhaust port 31.

A pressure sensor 35 measuring and monitoring a pressure inside the reaction tube 10 is installed at the upper end portion 15 of the reaction tube 10. A pressure sensor 36 measuring and monitoring a pressure inside the hermetic case 13 (shielded space) is installed in the hermetic case 13. To the discharge port 26 of the hermetic case 13, there are attached an oxygen concentration meter 37 measuring and monitoring an oxygen concentration of the shielding gas discharged from the inside of the hermetic case 13 and a hydrogen detector 38 detecting hydrogen in the shielding gas. An oxygen concentration meter 39 is attached to the collection room 30.

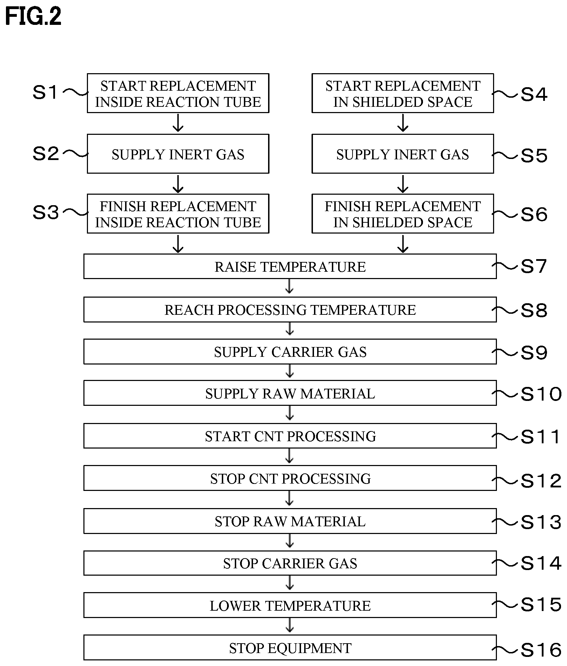

Next, a method for manufacturing the CNT in the CNT manufacturing apparatus 1 configured as above will be described with reference to FIG. 2. Note that among operations such as supply and stop of each gas and raw material as well as collection of the CNT which are described below, operations that can be performed automatically may be performed automatically via a control unit (not shown) or may be performed manually by an operator.

First, as a preparation stage, gas replacement inside the reaction tube 10 is started (S1). That is, an inert gas is supplied into the inside of the reaction tube 10 from the inlet unit 16 provided at the upper end portion 15 of the reaction tube 10 (S2), and the inside of the reaction tube 10 is replaced with an inert atmosphere (S3).

Note that since the spaces of the reaction tube 10 and the collection room 30 are connected, by replacing the inside of the reaction tube 10 with the inert atmosphere, the inside of the collection room 30 is replaced at the same time. As a replacement method, there are a method of supplying an inert gas for a certain period and a method of repressurizing with an inert gas after vacuum evacuation.

In the method of supplying the inert gas for a certain period, an oxygen concentration can be lowered to a predetermined concentration or less by supplying the inert gas of a volume corresponding to four times a volume to be replaced. Hereinbelow, there is shown a relationship between a multiple of the volume to be replaced (multiple related to the volume of the spaces of the reaction tube 10 and the collection room 30) and the oxygen concentration in the volume when a set value of the oxygen concentration is 2.3% or less in the method of supplying the inert gas for a certain period.

**[Table 1]**

| METHOD OF SUPPLYING INERT GAS FOR CERTAIN PERIOD | |
|---|---|
| MULTIPLE OF VOLUME | OXYGEN CONCENTRATION IN VOLUME [%] |
| 0 | 21.0 |
| 1 | 10.5 |
| 2 | 5.3 |
| 3 | 2.6 |
| 4 | 1.3 |

In the method of repressurizing with the inert gas after vacuum evacuation, an ultimate vacuum value during vacuum evacuation is important, and evacuating to -90 kPaG or less can lower the oxygen concentration to a predetermined concentration. Hereinbelow, there is shown a relationship between an ultimate vacuum value at the time of vacuum evacuation and the oxygen concentration in the volume when the set value of the oxygen concentration is 2.3% or less in the method of repressurizing with the inert gas after vacuum evacuation.

**[Table 2]**

| METHOD OF VACUUM EVACUATION + REPRESSURIZING WITH INERT GAS | |
|---|---|
| ULTIMATE VACUUM VALUE [kPaG] | OXYGEN CONCENTRATION IN VOLUME [%] |
| 0 | 21.0 |
| -10 | 18.9 |
| -20 | 16.9 |
| -30 | 14.8 |
| -40 | 12.7 |
| -50 | 10.6 |
| -60 | 8.6 |
| -70 | 6.5 |
| -80 | 4.4 |
| -90 | 2.3 |
| -95 | 1.3 |
| -100 | 0.3 |
| -101.3 | 0.0 |

Meanwhile, gas replacement inside the hermetic case 13 (inside the shielded space) is started (S4). That is, by discharging a certain amount of shielding gas (inert gas) from the discharge port 26 while making a certain amount of shielding gas flow from the supply port 25 provided at the lower portion of the hermetic case 13 into the hermetic case 13 (S5), the internal space of the hermetic case 13 is replaced with the inert atmosphere (S6).

Thereafter, in the production apparatus 2, a temperature of the reaction tube 10 is raised by heating by means of the heater 11 (S7), and when the temperature of the reaction tube 10 reaches a processing temperature (S8), a carrier gas (e.g., hydrogen gas) is supplied into the inside of the reaction tube 10 through the inlet unit 16 provided at the upper end portion 15 of the reaction tube 10 (S9), and a raw material gas such as a carbon source, a catalytic metal, or a catalytic metal compound is supplied (S10). Thus, the CNT processing starts (S11), and the CNT is produced.

Then, the produced CNT is discharged from the lower end portion 20 of the reaction tube 10 together with the carrier gas and collected in the collection room 30. Note that the carrier gas supplied from the reaction tube 10 into the collection room 30 is discharged through the exhaust port 31. Further, the shielding gas supplied from the supply port 25 is discharged via the discharge port 26.

Meanwhile, when the CNT processing is to be finished (S12), first, the supply of the raw material into the reaction tube 10 is stopped (S13), and next, the supply of the carrier gas is stopped (S14). Then, the heating by the heater 11 is stopped, and thereby the temperature of the reaction tube 10 is lowered (S15). Thus, the manufacturing of the CNT by the CNT manufacturing apparatus 1 is finished, and the equipment is stopped (S16). By performing the above-described procedures, even if the reaction tube 10 is damaged, a risk of causing a fire by contact between the raw material gas containing hydrogen and a gas containing oxygen such as air can be substantially decreased.

Note that during the manufacturing of the CNT, the pressure inside the reaction tube 10 can be measured and monitored by the pressure sensor 35, the pressure inside the hermetic case 13 (shielded space) can be measured and monitored by the pressure sensor 36, and hydrogen in the shielding gas can be detected and monitored by the hydrogen detector 38. In addition, the oxygen concentration of the shielding gas discharged from the inside of the hermetic case 13 can be measured and monitored by the oxygen concentration meter 37, and the oxygen concentration of the carrier gas exhausted to the collection room 30 can be measured and monitored by the oxygen concentration meter 39.

In a case where the pressure inside the hermetic case 13 (shielded space) is too large relative to the pressure inside the reaction tube 10, the shielding gas enters the reaction tube 10 from parts of the packings 21 for sealing which are attached to both end portions of the reaction tube 10, affecting the production of the CNT. For this reason, it is preferable to perform control of notifying an abnormality when the pressure inside the hermetic case 13 which is measured by the pressure sensor 36 has a certain pressure difference or more relative to the pressure inside the reaction tube 10 which is measured by the pressure sensor 35.

Note that during the manufacturing of the CNT, an internal pressure of the shielded space is preferably set higher than an internal pressure of the reaction tube 10. For example, a flow rate of the shielding gas is set such that a differential pressure between the internal pressure of the reaction tube 10 and the pressure inside the hermetic case 13 (shielded space) is within a range of 0 to 2 kPaG.

Further, in a case of monitoring intrusion of the hydrogen gas from the reaction tube 10 into the shielded space using the hydrogen detector 38, an abnormality may be notified when the hydrogen detector 38 detects hydrogen in the shielding gas.

In addition to the abnormality notification upon detection of carrier gas (hydrogen gas) leakage from the reaction tube as described above, automatic control by constantly monitoring the differential pressure between the reaction tube and the shielded space is also possible. For example, when it is determined that the carrier gas (hydrogen gas) is leaking into the shielded space beyond a normal value range, control is possible such as abnormality notification associated with hydrogen gas detection, or stopping the hydrocarbon raw material and the carrier gas and introducing nitrogen gas.

Further, in a case where the oxygen concentration meter 39 is used, when it is detected that the oxygen concentration of the carrier gas exhausted to the collection room 30 has reached a set value or more, supply of the carrier gas may be stopped, heating by the heater 11 may be turned off, and a large flow rate of inert gas may be supplied into the reaction tube 10 and the collection room 30 to achieve replacement, thereby urgently stopping the manufacturing of the CNT by the CNT manufacturing apparatus 1. Note that during the manufacturing of the CNT, the oxygen concentration of the carrier gas is set in a range of 0 to 4% which is outside an explosion limit range of the hydrogen gas, and is desirably set to 2.3% or less.

Further, in a case of using the oxygen concentration meter 37, when it is detected that the oxygen concentration of the shielding gas discharged from the inside of the hermetic case 13 has reached a set value or more, the supply of the carrier gas may be stopped, the heating by the heater 11 may be turned off, and a large flow rate of inert gas may be supplied into the reaction tube 10 and the collection room 30 to achieve replacement, thereby urgently stopping the manufacturing of the CNT by the CNT manufacturing apparatus 1. Note that during the manufacturing of the CNT, the oxygen concentration of the shielding gas is set in a range of 0 to 4% which is outside the explosion limit range of the hydrogen gas, and is desirably set to 2.3% or less.

As described above, by performing control using the pressure sensors 35, 36, the oxygen concentration meter 37, the hydrogen detector 38, and the oxygen concentration meter 39, it is possible to enhance an effect of preventing oxidation of the reaction tube 10 made of a material that is easily oxidized at a high temperature, and even if leakage of the carrier gas from the reaction tube 10 occurs, occurrence of leakage can be detected.

According to the CNT manufacturing apparatus 1 according to the present embodiment described above, during the manufacturing of the CNT, the inside of the hermetic case 13 can be constantly maintained in the inert gas atmosphere by discharging a certain amount of shielding gas (inert gas, nitrogen, argon, etc.) from the discharge port 26 while making a certain amount of shielding gas flow from the supply port 25 provided at the lower portion of the hermetic case 13 into the hermetic case 13. Thereby, oxidation of the reaction tube 10 at high temperatures can be suppressed, so that it is possible to provide the carbon nanotube production apparatus 2 in which the leaked gas is safely discharged to the outside of the apparatus even when the leakage of the carrier gas from the reaction tube occurs due to deterioration by oxidation. By heating the reaction tube 10 in the inert gas atmosphere, options for the material for the reaction tube 10 increase, and restrictions on CNT manufacturing conditions and equipment specifications are removed, which consequently leads to improvement in manufacturing capacity and cost. Since a heating source space (shielded space) is filled with the inert gas atmosphere, it becomes possible to employ the heater 11 that is susceptible to oxidation at high temperatures, options for a heating source (heater 11) increase, and the range of heating conditions can be widened, which leads to improvement and enhancement of CNT manufacturing conditions and equipment specifications.

Moreover, even in the event that the reaction tube 10 or a related part is damaged while the production reaction is being processed by supplying the raw material and the carrier gas, the flammable gas, which is the carrier gas, can be safely discharged to the outside of a factory together with the shielding gas in a manner that prevents leakage.

Note that while an example is shown in which the hole 27 allowing the shielding gas to flow is provided in the heat insulator 12, the hole 27 is not necessarily required because the heat insulator 12 does not have airtightness, and the hole 27 is provided for the purpose of shortening the time for replacement from atmospheric air to the inert gas atmosphere. Therefore, the hole 27 may be omitted.

As for a positional relationship between the supply port 25 supplying the shielding gas into the inside of the hermetic case 13 and the discharge port 26 discharging the shielding gas from the inside of the hermetic case 13, it is desirable to provide the discharge port 26 at a place farthest from the position of the supply port 25 and at an extreme end of the hermetic space so that there is no atmospheric air pocket in the hermetic space and that atmosphere replacement is surely performed. For example, when the equipment is a horizontal type, a gas is supplied from a bottom of one end of a hermetically shielded space and discharged from a top of an opposite end of the hermetically shielded space.

Although the embodiments of the present invention have been described above, the present invention is not limited to such examples. It is obvious that those skilled in the art can conceive of various changes or modifications within the scope of the technical idea described in the claims, and it is understood that these naturally belong to the technical scope of the present invention.

For example, constituent elements of the above-described embodiments can be combined arbitrarily. From such arbitrary combinations, the functions and effects of the respective constituent elements can naturally be obtained, and other functions and effects obvious to those skilled in the art from the description of this specification can also be obtained.

Further, the effects described in this specification are merely explanatory or exemplary and are not limited. That is, the technology according to the present disclosure can exhibit other effects obvious to those skilled in the art from the description of this specification, in addition to or instead of the above effects.

### INDUSTRIAL APPLICABILITY

The present invention is applicable to an apparatus producing a carbon nanotube.

### EXPLANATION OF CODES

- 1: CNT manufacturing apparatus
- 2: CNT production apparatus
- 3: collection apparatus
- 10: reaction tube
- 11: heater
- 12: heat insulator
- 13: hermetic case
- 15: upper end portion
- 16: inlet unit
- 20: lower end portion
- 21: packing
- 25: supply port
- 26: discharge port
- 27: hole
- 30: collection room
- 31: exhaust port
- 35: pressure sensor
- 36: pressure sensor
- 37: oxygen concentration meter
- 38: hydrogen detector
- 39: oxygen concentration meter

## Claims

1. A carbon nanotube production apparatus producing a carbon nanotube, the carbon nanotube production apparatus comprising:
a reaction tube to which a raw material gas for the carbon nanotube is supplied;
a heater disposed circumferentially around the reaction tube;
a heat insulator covering an outside of the heater;
a hermetic case that hermetically encloses a periphery of the reaction tube and houses the heater and the heat insulator;
a supply port supplying a shielding gas into an inside of the hermetic case; and
a discharge port discharging the shielding gas from the inside of the hermetic case.

2. The carbon nanotube production apparatus according to claim 1, wherein,
the supply port is provided at a lower portion of the hermetic case, and the discharge port is provided at an upper portion of the hermetic case.

3. The carbon nanotube production apparatus according to claim 1, configured to monitor a differential pressure between an inside of the reaction tube and a space to which the shielding gas is supplied, and to prevent leakage of the shielding gas into the reaction tube upon damage to the reaction tube by automatically adjusting a supply flow rate of the shielding gas when the differential pressure exceeds a set range.

4. A carbon nanotube manufacturing apparatus, comprising:
the carbon nanotube production apparatus according to any one of claims 1 to 3; and
a collection apparatus collecting the carbon nanotube.
